(19) Europäisches Patentamt
European Patent Office
Office européen des brevets

(11) Publication number: 0 306 973 A2

# (12) EUROPEAN PATENT APPLICATION

(21) Application number: 88114783.9

(22) Date of filing: 09.09.88

(51) Int. Cl.⁴: C04B 35/00 , C04B 35/64 , C01G 1/00 , H01L 39/00

Claims for the following Contracting State: ES.

(30) Priority: 11.09.87 US 95083
12.02.88 US 155340
15.07.88 US 219677

(43) Date of publication of application:
15.03.89 Bulletin 89/11

(84) Designated Contracting States:
AT BE CH DE ES FR GB GR IT LI LU NL SE

(71) Applicant: W.R. Grace & Co.-Conn. (a Connecticut corp.)
Grace Plaza 1114 Avenue of the Americas
New York New York 10036(US)

(72) Inventor: Spencer, Nicholas David
5311 42nd St., N.W.
Washington Columbia 20015(US)
Inventor: Pan, Wie Hin
5431 The Bridle Path
Columbia Maryland 21044(US)
Inventor: Rudesill, John Allen
10824 Hilltop Lane
Columbia Maryland 21044(US)

(74) Representative: Abitz, Walter, Dr.-Ing. et al
Abitz, Morf, Gritschneder, Freiherr von Wittgenstein Postfach 86 01 09
D-8000 München 86(DE)

## (54) Manufacturing method for superconducting ceramics and products thereof.

(57) An extremely pure oxide containing two or more metals, homogeneous at the atomic level, is prepared by (1) reacting in water, soluble salts of two or more metals with quaternary ammonium carbonate; the metals being those that form water-insoluble carbonates, thereby to precipitate mixed carbonates of the metals; (2) recovering and drying the precipitate; (3) calcining the precipitate to provide an oxide of mixed metals homogeneous at the atomic level and substantially free from extraneous contaminants. The calcined oxide can be shaped and compressed as greenware and sintered to form useful ceramic products. For example a solution of nitrates of yttrium, barium, and copper are treated with a solution of tetraethyl ammonium carbonate to form co-precipitated carbonates of Y, Ba, Cu.

EP 0 306 973 A2

# MANUFACTURING METHOD FOR SUPERCONDUCTING CERAMICS AND PRODUCTS THEREOF

This application is a continuation-in-part of U.S. Patent Application Serial No. 155,340 filed February 12, 1988 which is a continuation-in-part of U.S. Patent Application Serial No. 095,083 filed September 11, 1987, both of which are herein incorporated by reference in their entireties.

## RELATED APPLICATION

U.S.S.N. 095,084, filed September 11, 1987, Spencer and Cheng discloses and claims spray drying metal salts adapted to the preparation of superconductors.

## FIELD OF THE INVENTION

This invention relates to the preparation of superconducting ceramics and more particularly to an improvement in preparing the metal oxide system generically represented by L.M.A.D. where (e.g.) L may be yttrium; M may be barium; A, copper; and D, oxygen.

## BACKGROUND OF THE INVENTION

It has long been known that the effective resistivity of certain metals was sometimes substantially eliminated , when the metal was exposed to low temperature conditions. Of particular interest were the metals and metal oxides which can conduct electricity under certain low temperature conditions with virtually no resistance. These have become known as superconductors. Certain metals, for example, are known to be superconductive when cooled to about 4° on the Kelvin scale (°K), and certain niobium alloys are known to be superconductive at about 15°K, some as high as about 23°K. More recently, an oxide containing lanthanum, barium, and copper was discovered which became superconductive at temperatures of about 30°K, and in some circumstances, at temperatures of about 20 degrees higher. Current advances have identified materials which become superconductive at temperatures near 100°K, such that liquid nitrogen cooling could be used. Of special interest are ceramic materials which have reduced electrical resistance properties that are stable over time such that they could be developed for use in practical applications. While the phenomena of reduced electrical resistance and even superconductivity has now been observed at liquid nitrogen temperatures or above, these properties are still considered to be achieved primarily at low temperatures when compared to ambient conditions. However, there is some indication that ceramic materials might be formulated which can reliably exhibit reduced electrical resistance and perhaps superconductivity at ambient conditions.

A composition having an approximate unit cell formula of $Y.Ba_2.Cu_3.O_z$, where z is typically about 7, and various related materials, represents a particularly promising group of ceramics for superconducting applications. The compositions are typically formulated from precursors which can be mixed to provide the desired ceramic. In one formulation for these ceramic materials, for example, carbonate and/or oxide powders of the solid elements are mixed and raised to a temperature of about 1,000°C, driving off volatile materials, such as carbon dioxide. The mixture is reground and reheated, ordinarily several times to improve the intimacy of the mixture, and then can be pelletized, sintered for several hours, and then gradually cooled to below 250°C.

Pellets have proven convenient for research applications properly involving ceramic superconductive materials since they can be readily formed by pressing together the powdered materials and binding them by a sintering process. These ceramic materials are typically brittle such that they are also more readily handled in pellet form. However, commercial applications of superconductors are likely to require substantial quantities of such materials in useful shapes such as tubes, rods, wires, or sheets, and other techniques for conveniently and reliably shaping these ceramic materials while maintaining their ability to conduct electricity with reduced resistance are being sought.

Reportedly, one procedure has been developed in which the ceramic powder is encased in a thin tube of metal such as silver, and then drawing the filled tube to form a wire. Evaporative techniques have also been reportedly used to produce films of superconducting materials from multiphase material comprising yttrium, barium, copper, and oxygen. In still another procedure, the ceramic powder, or even its ingredients, are mixed into an organic binder such as polyethylene glycol which is then extruded to form a plastic wire. After the wire is formed into the desired shape, the binder is burnt off and the residual powders are sintered to form the product filament. Tapes have also been produced by embedding ceramic particles in organic material to produce a flexible tape which can be shaped and then sintered. The conductive performance of the final ceramic material is known to be dependent upon the uniformity of element distribution throughout the composition. A common objective in any of the techniques for formulating and processing superconductive materials is to assure intimate mixing of precursor materials to provide a relatively homogeneous ceramic produce.

## SUMMARY OF THE INVENTION

An extremely pure mixture of two or more metal oxides, homogeneous at the atomic level, is prepared by (1) reacting in water, soluble salts of two or more metals with quaternary ammonium carbonate; the metals being those that form water-insoluble carbonates, thereby to precipitate mixed carbonates of the metals; (2) recovering and drying the precipitate; (3) calcining the precipitate to provide mixed metal oxides homogeneous at the atomic level and substantially free from extraneous contaminants.

Use of the quaternaries permits: i) facile pH control (essential for co-precipitation of various of the carbonates); ii) exclusion of additional metals, such as K in $K_2CO_3$ as used in prior carbonate processes; iii) ready burn-off of the carbonate source in the furnace; and iv) stoichiometric co-precipitation, without formation of interfering complexes or coordination compounds.

The metal oxides made in this invention are useful as ceramics, and certain mixes have specialty uses based on their extreme purity, durability, and electrical conductivity, e.g., as laser cathodes, electrodes in chlorine/caustic electrolysis, etc.

### References

Oxides of La.Sr.Co are not novel as cathodes for $CO_2$ lasers. See N. Karube et al., "Sealed-off $CO_2$ lasers with $La_{1-x}Sr_xCo_3$ oxide cathodes," Appl. Phys. Lett., 43, 1086 (1983); and N. Iehisa et al., "Performance Characteristics of sealed-off $CO_2$ laser with $La_{1-x}Sr_xCoO_3$ oxide cathode," J. Appl. Phys., 59, 317 (1986). However, the herein described method of preparing such materials is believed novel.

Using a novel technique, we coprecipitate our L.M.A. metallic cations as carbonates. This technique provides an initial superior homogeneity of L.M.A., and this homogeneity is maintained throughout subsequent processing steps. The crux of our new technique is our carbonate ion source: viz., a quaternary ammonium carbonate. Use of the quaternaries permits: i) facile pH control (essential for co-precipitation of the carbonates); ii) exclusion of additional metals, such as $K_2CO_3$ as used in prior carbonate processes; iii) ready burn-off of the carbonate source in the furnace; and iv) stoichiometric co-precipitation, without formation of interfering complexes or coordination compounds.

## DETAILED DESCRIPTION OF THE INVENTION

### Solution A, the Carbonate Reagent

A solution of quaternary ammonium carbonate is conveniently prepared by bubbling $CO_2$, through an aqueous solution of a quaternary ammonium hydroxide until the quaternary carbonate is stoichiometrically formed and $CO_2$ is dissolved in excess. The preferred quaternary ammonium hydroxides have the formula:

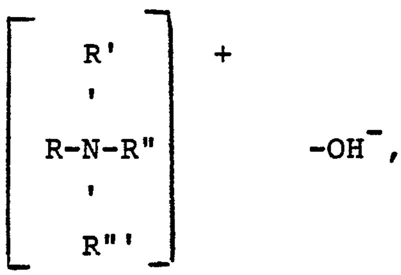

where R, R′, R″, R‴ are the same or different members of the group

i) alkyl, e.g., tetramethylammonium hydroxide, tetraethylammonium hydroxide, tetrapropylammonium hydroxide, dimethyldiethylammonium hydroxide, cyclopropyltrimethylammonium hydroxide and the like;

ii) aromatic, e.g., phenyltrimethylammonium hydroxide, phenylethyldimethylammonium hydroxide, benzyltrimethylammonium hydroxide, and the like;

iii) heterocyclic;

iv) and any two group members may be joined in a ring whereby N becomes a ring member, e.g., dimethyl pyrrolidinium hydroxide, dimethylpyridinium hydroxide, and the like.

### The Metals

The invention process is a general one and is applicable to any metals (a) that provide water-soluble salts (nitrates, acetates, etc.,) and (b) which form water-insoluble carbonates. The carbonates in various instances are actually the basic carbonates, subcarbonates etc. It makes no difference, the important thing being water-insolubility. Here again it should be borne in mind that all carbonates are to some extent water-soluble. Those that are difficultly soluble are intended for use in this invention, e.g., those having solubilities roughly comparable to the carbonates of the alkaline earth metals.

Some of the preferred metals (that have insoluble carbonates, as the term is used herein) are:

(1) The rare earths, i.e., elements with atomic numbers 57-71 inclusive.

(2) Alkaline earth metals (Be, Mg, Ca, Sr, Ba).

(3) Cu, Ag, Au.

(4) Mn, Fe, Co, Ni.

(5) Zn, Cd, Hg.

(6) Pb, Bi.

(7) Sc, Y.

(8) Zr.

## Solution B, the Metal Salts

An aqueous solution of the L.M.A. metal salts (as hereinafter defined) is made up by dissolving their nitrates or other water-soluble salts in water, so as to provide the predetermined L.M.A. atomic ratio for the superconductor (eg. yttrium nitrate, barium nitrate, and copper nitrate may be dissolved in water so that yttrium, barium, and copper ions are present in the solution in a ratio of substantially 1:2:3). The metal atomic ratios will depend on the end use intended. Typically, any given metal may be present in an atomic ratio of 1-100, suitably 1-10, with respect to any other metal. However, when it is desired to introduce very small amounts of a given metal, this ratio will vary accordingly.

For use in this invention, L is at least one trivalent metal (i.e. valence of +3) such as yttrium or bismuth, and is preferably selected from yttrium, scandium, and the other rare earth group elements (elements with atomic numbers 57-71). M is at least one bivalent metal (i.e. valence of +2) such as Ba or Sr, and is preferably selected from the group Ba, Be, Mg, Ca, and Sr; and A is at least one metal of multiple valency (i.e. more than one valence state) such as Cu or Nb, and is preferably selected from the group Cu, Ag, and Au.

We prefer Y, Ba, and Cu in an atomic ratio of 1:2:3. This results in an amount of oxygen in the calcined product equal to about 7 (or a little less) atoms per atom of Y.

## The Co-carbonate Slurry

Solutions A and B are now added slowly, simultaneously, at constant rates, with stirring, to a pool ("heel") of deionized water. This pool is the reaction medium for the carbonate co-precipitation reaction,and the eventual result is a carbonate slurry. Solutions A and B and the heel are suitably each about the same starting volume. The pH should be maintained at about 7.5 or above, suitably between 7.5 and 12, e.g. at about 7.7-10.0, during co-precipitation. For example, the pH of the reaction mass may be maintained at about 7.7-8.0 by dropwise addition of a quaternary ammonium hydroxide. The precipitated carbonates can be recovered from the slurry using various techniques. On a laboratory scale simple filtration followed by air drying the precipitate is adequate for good homogeneity.

When the carbonate precipitation is complete, the resulting slurry consists essentially of

i) L.M.A. carbonates, about 0.5-75 wt%;

ii) quaternary ammonium cations, about 0.1-75 wt%;

iii) anions residual from the starting L.M.A. salts, stoichiometrically equivalent to the L.M.A. carbonates; and

iv) balance, water.

This novel carbonate-containing slurry is per se an essential part of our invention. The filtered and air-dried precipitate recovered from this slurry is generally friable and easily crumbled.

## Calcination

Starting with the direct carbonate precipitate, we calcine according to the the following program:

1) The precipitate is placed in an alumina boat, which is then placed in an electric furnace, in flowing air.

2) The furnace is brought up to about 600° C to 1400° C, the precise calcining temperature range depending upon the metal composition. Generally, the preferred temperature range is from about 850°-1050° C, suitably 950°. The time required to bring the furnace up to temperature is not critical. At least a few minutes is, however, generally necessary, depending on the structure and operation of the furnace.

3) The furnace is maintained at the temperature selected in 2) for about 4-8 hours, suitably about 6 hours.

4) Next, the furnace is gradually cooled over a period of time (linear cooling). This step is important. We prefer to cool down to about room temperature to 250°C over 5-12 hours, suitably 8 hours. Cooling is preferably accomplished in an atmosphere of $O_2$.

(Comment: At this stage the calcined product - a powder - is superconducting. To facilitate the levitation test, it may be compressed into a wafer.)

We have found that a useful organic-free intermediate can be prepared by heating the dried co-precipitate recovered from the co-carbonate slurry to a temperature sufficient to decompose or otherwise volatilize any remaining quaternary ammonium and nitrate material, and to achieve partial conversion of the carbonates in the co-precipitate to oxides. For example, an yttrium-barium-copper co-precipitate from nitrate salts may be heated to about 540°C to remove quaternary ammonium and nitrate material and to convert yttrium and copper carbonates to their respective oxides. These intermediates are generally powders which can be conveniently stored, shipped, or processed and can be easily transformed to superconductors by the calcination procedure as described above.

Mention may be made of certain references in the literature.

Wu et al, Superconductivity at 93K is a New Mixed Phase Y-Ba-Cu-O Compound System at Ambient Pressure, Physical Review Letters, 58, 908-910 (2 March 1987) discloses making the title compounds by solid state reaction of $Y_2O_3$, $BaCO_3$, and CuO.

Engler et al, Superconductivity above Liquid Nitrogen Temperature: Preparation and Properties of a Family of Perovskite-Based Superconductors, J. Am. Chem. Soc. 109, 2848-2849 (1987), mixes $Y_2O_3$, $BaCO_3$, and CuO in a ball mill to give a 1:2:3 ratio of Y, Ba, Cu. The powder was heated in an alumina boat at 950°C, and the resulting black powder was reground and heated again.

Wang et al, Comparison of Carbonate, Citrate, and Oxalate Chemical Routes to the High-$T_c$ Metal Oxide Superconductors $La_{2-x}Sr_xCuO_4$, Inorg. Chem. 26, 1474-1476 (1987). This was the only reference we found using a carbonate precipitation technique. The precipitant was $K_2CO_3$. According to the paper, it was necessary to wash the precipitate repeatedly, an obvious disadvantage in production work. Washing was necessary because potassium adversely affects superconductivity properties of the finished material. If we wash repeatedly, we remove barium, a highly detrimental loss in our process.

From the technical viewpoint it may seem obvious that co-precipitated carbonates would provide enhanced homogeneity. However, the technical solution to the problem proved frustrating and was marked by an initial series of failures. We noted that the Wang et al process, using potassium carbonate (or sodium carbonate) necessitated numerous washings and apparently left detectable amounts of alkali in the ceramic base even so. As noted, serial washings remove Ba, and would be unworkable in our process. We looked for a carbonate that would burn off completely, and for this we tried ammonium carbonate. Here we found that we had to use a pH below 7 to prevent formation of copper tetraamine but that under these conditions $HCO_3^-$ ion was formed, and that barium bicarbonate, being slightly soluble, was formed and disrupted our desired stoichiometry. Oxalates looked interesting, but we found that these form oxalate complexes with yttrium that retain it in solution. Our research in this area was finally capped with the quaternary ammonium carbonates, as above described. These compounds, so far as our work to date shows, form the desired metal carbonates simply and cleanly, without troublesome side-formation of complexes or coordination compounds, with firm and precise retention of the intended stoichiometry; which do not interfere with filtration, or similar recovery operations; which do not introduce contaminants into the final product; and which result in homogeneous particles that do not require grinding. The reaction in the reaction mixture is of course ionic, that is, carbonate ions react with the respective metal ions to form the respective metal carbonate precipitate.

The following examples illustrate without limiting the invention.

## Example 1

Carbon dioxide (from dry ice) was bubbled through 0.405 moles of 40 wt% tetraethylammonium (TEA) hydroxide until the pH was 8.3 to form $TEA_2CO_3$ and/or $TEAHCO_3$. The solution was diluted to 250 cc. 0.016 moles yttrium nitrate, 0.032 moles barium nitrate, and 0.048 moles copper nitrate were dissolved in deionized water to make 250 cc solution. The two solutions were slowly dripped into a heal of 300 cc deionized water with stirring. The pH was maintained at about 7.7-8.0 by the dropwise addition of a solution of TEAOH (40wt%). The TEAOH solution has a pH of 14-15. The light blue precipitate was filtered, then dried at 110°C overnight and fired in flowing air. The firing program involved a ramp to 950°C over 6 hours, maintaining 950°C for 6 hours, then linearly cooling to 150°C over 8 hours. The resulting black solid, when compressed (180001bf, 3/4"-diameter die) into a wafer, could levitate a magnet at liquid

nitrogen temperatures. Other products have been made on a larger scale using tetramethyl ammonium hydroxide (TMA) as the quaternary ammonium compound and cooling under oxygen following calcination in air at about 920°C.

$\Delta T_c$

Our superconducting ceramic product shows a relatively narrow $\Delta T_c$, indicating a high degree of purity and homogeneity. By "Delta $T_c$" we mean the width of the resistivity curve as it leaves the zero resistivity line at some particular temperature $T_c$ rises (generally sharply) with rising temperature (indicating increasing resistivity and loss of superconductivity) and then levels off asymptotically at another particular temperature, indicating complete or substantially complete loss of superconductivity and entry of the ceramic into the world of normal resistance/conductivity.

## Example 2

116.20 g $La(NO_3)_3.5\ H_2O$
25.50 g $Sr(NO_3)_2$
116.40 g $Co(NO_3)_2.6\ H_2O$

The above nitrates were placed in a 1-L beaker. Deionized water was added to make a 800-ml solution. 800 ml, pH 10.00 tetramethylammonium carbonate, produced by bubbling $CO_2$ into 25 wt. % aqueous tetramethylammonium hydroxide, was placed in a separate 1-L beaker. An 800 ml deionized water "heel" was placed in a 4-L beaker. pH of the 3-metal nitrate solution was 3.90. Simultaneously, the nitrate solution and the tetramethylammonium carbonate solution was dripped into the heel, keeping the heel pH at about 9 using neat tetramethylammoniumhydroxide, which is dripped separately into the heel from a 500 ml burette. About thirty minutes was required to add the two reactant solutions to the heel. An extra 335 mls neat tetramethylammonium hydroxide were added to keep the pH at 9.01. The solution was allowed to "age" by stirring for twenty minutes, to aid subsequent filtration. The resulting purple solution was filtered through double-thickness filter paper with a Buechner funnel. Filtration proceeded overnight. The semi-dry cake was placed in a glass tray, which was placed in a 100°C convection oven where it was allowed to dry. Weight of purple cake, 185.02 g. The cake pieces were broken up with mortar and pestle. 46.00 g of the resulting powder was placed in a platinum crucible and calcined in air, as follows: 8 hours to 900°C; 8 hours at 900°C; then power off, and allowed to cool to room temperature. The resulting powder was determined by x-ray diffraction to be homogeneous at the atomic level and phase pure.

## Extraneous Materials

We have mentioned that prior art processes conventionally enhance homogeneity by grinding the calcined superconductor, followed by recalcining. In some instances this sequence may be repeated several times. It is known that improved homogeneity in the general case enhances superconductivity. The problem here is that effective grinding inevitably and inherently introduces trace impurities into the ceramic, simply by impacting the ceramic between the balls and walls (or other grinding surfaces) of the grinding mill. It is known, for example, that silica or stainless steel balls in a ball mill lose significant mass over a period of use. This mass of course disappears into whatever was being milled. Mills that comminute by particle self-impact lose metal by wall-scouring, particularly in the area of stream entry.

Thus, the firing-grinding-refiring technique rapidly achieves a balance: improvement in homogeneity tends to be matched by contamination build-up that cancels part or all of the improvement.

Our process, by achieving ultimate homogeneity in the first place, avoids the grinding problem altogether. Our product can, of course, be subjected to the conventional firing-grinding-refiring cycle, but this is not our preferred technique. Our process works best, and our best superconductors are obtained, when no extraneous materials are introduced into the material at any stage. By "extraneous materials" we mean materials (other than those which can be volatilized during calcination) introduced into the base metal solution to precipitate the carbonates, e.g., potassium carbonate to precipitate Y, La, Ba, Sr, Cu and Co carbonates. The term also includes contaminants (generally metals or metal oxides) introduced into the composition by grinding the L.M.A.D. composite. If the product is ground in a ball mill using quartz or silica balls, some of the impurity is silica.

The extreme purity and homogeneity of the mixed oxide powders of the invention qualify the powders for specialty uses. Particularly useful products can be prepared by compressing the powders into greenware ceramic shapes, suitably followed by sintering. Such compression may be extrusion, compression in a pellet mold, etc. Where

extreme pressures are desired, uniformly applied (especially for intricate shapes), cold isostatic pressing ("c-i-p") is eminently useful. This technique is well-known.

Levitation Test for Superconductivity

Various tests are available for the determination of superconductivity. One of these tests is conventional, simple, and is accepted in the art as definitive. We used this, the so-called levitation test, in our determinations, and we describe it below.

A circular wafer of the compound is prepared by calcining and compressing as described in Example 1. The wafer is about 1-inch in diameter and about 3/16-inch thick. It is placed in the center of a glass dish, and then liquid nitrogen (77° K) is poured into the dish.

The wafer bubbles a bit at first, as the nitrogen boils on contact, and as surface air is flushed from the wafer. In a few minutes gas evolution diminishes to nearly zero, and the wafer may be assumed to be chilled to approximately the temperature of liquid nitrogen. A chip of a rare earth magnet is now dropped gently over the wafer. If the magnet levitates, i.e., hovers in the air over the wafer, the wafer is superconducting. (Comment: Instances have been reported where the magnet sank; yet measurable superconductivity existed and was detectable by more sophisticated means. But a positive test, such as we achieved in our runs, shows certain superconductivity.)

Laser Cathode

A low-resistance cathode tube for a $CO_2$ laser was prepared by placing 40 g of the calcined powder from Example 2 into a rubber mold, which was then cold-isostatically pressed at 20,000 psi. In determining dimensions of the mold, the final dimensions desired, as affected by shrinking in the c-i-p and subsequent sintering operations, had to be taken into account. The greenware shrinks about 15% linearly during c-i-p and another 22% (approximate) during sintering. Overall shrinkage in this particular instance is thus about (1-0.15) x (1-0.22) = 0.66, so mold dimensions are suitably 1/0.66 x final compacted and sintered dimensions, i.e., about 1.5 x. This factor may vary somewhat depending on compaction pressure, sintering schedule, powder composition, etc. In this case the final dimensions of the cathode tube were about 1" long by 1/2" diameter, with tube walls about 1/8" thick.

Following c-i-p, the greenware was placed on a support bed of alumina grit in an alumina boat, which was placed in a furnace, and the greenware was sintered in air per the following schedule (all °C): 3 hours from room temperature to 1050°; 6 hours at 1050°, 1/2 hour to 1150°, then 6 hours at 1150°, then 1/2 hour to 575°, then power off and allow to cool to room temperature.

**Claims**

1. Composition consisting of an oxide containing at least two metals, the metals being those that form water-insoluble carbonates, characterized in that the oxide is homogenous at the atomic level and is free from extraneous materials.

2. Composition according to Claim 1 wherein at least one of the metals is of the group: the rate earths; the alkaline earths; Cu, Ag, and Au; Mn, Fe, Co, and Ni; Zn, Cd, and Hg; Pb and Bi; and Sc, Y, and Zr.

3. Superconducting metal oxide composition L.M.A.O. in which L is at least one trivalent metal, M is at least one bivalent metal, A is at least one metal of multiple valency; and in which L, M, and A are present in the predetermined atomic ratio for the superconductor;
characterized in that the composition is free of extraneous materials.

4. Composition according to Claim 3 in which L is Y, M is Ba, A is Cu, in a respective atomic ratio of 1:2:3.

5. Composition according to Claim 3, being $La_{0.7}Sr_{0.3}CoO_3$.

6. The superconducting composition of Claim 3 wherein L is at least one metal of the rare earth group, including scandium and yttrium; M is at least one metal of the group Ba, Be, Mg, Ca, and Sr; A is at least one metal of the group Cu, Ag, and Au; and O is oxygen.

7. The superconducting composition of Claim 6 which is a product of a process comprising the steps of:

(a) preparing a solution of soluble salts of L, M, and A with the components L, M, and A in said predetermined atomic ratio;

(b) preparing a solution of quaternary ammonium carbonate;

(c) mixing said L.M.A. and quaternary ammonium carbonate solutions by simultaneously stirring them into a pool of water to form a stoichiometric co-precipitate;

(d) recovering said co-precipitate; and

(e) calcining the co-precipitate.

8. The superconducting composition of Claim 7 which is produced by a process in which calcining is accomplished by heating the dried co-precipitate to a temperature of about 850°-1050°C; holding that temperature for about 4-8 hours; and linearly cooling down to a temperature in the range of about room temperature to 250°C over about 5-12 hours.

9. Aqueous slurry consisting essentially of a homogeneous dispersion of a coprecipitate of at least two metal carbonates and quaternary ammonium salts.

10. Slurry according to claim 9 wherein at least one of the metal carbonates is a carbonate of a metal of the group: the rare earths, the alkaline earths; Cu, Ag, and Au; Mn, Fe, Co, and Ni; Zn, Cd, and Hg; Pb and Bi; and Sc, Y, and Zr.

11. Aqueous slurry consisting essentially of homogeneous dispersion of L.M.A. carbonates and quaternary ammonium salts, where L is at least one trivalent metal, M is at least one bivalent metal; and A is at least one metal of multiple valency.

12. The aqueous slurry of Claim 11 where L is at least one metal of the rare earth group including scandium and yttrium; M is at least one metal of the group Ba, Be, Mg, Ca, and Sr; and A is at least one metal of the group Cu, Ag, and Au.

13. Slurry according to Claim 11 wherein L.M.A. is Y.Ba.Cu in an atomic ratio of 1:2:3.

14. Aqeuous slurry according to Claim 13 consisting essentially of

i) L.M.A. carbonates, about 0.5-75 wt%;

ii) quaternary ammonium cations, about 0.1-75 wt%;

iii) anions residual from the starting L.M.A. salts, stoichiometrically equivalent to the L.M.A. carbonates; and

iv) balance, water.

15. Organic-free composition suitable for transformation by calcination into a superconducting metal oxide L.M.A.O., where L is at least one trivalent metal, M is at least one bivalent metal, and A is at least one metal of multiple valency; in which L, M, and A are present in a predetermined atomic ratio, which organic-free composition is a product of a process comprising the steps of:

(a) preparing a solution of soluble salts of L, M, and A with the components L, M, and A in said predetermined atomic ratio;

(b) preparing a solution of quaternary ammonium carbonate;

(c) mixing said L.M.A. and quaternary ammonium carbonate solutions by simultaneously stirring them into a pool of water to form a stoichiometric co-precipitate;

(d) recovering said co-precipitate; and

(e) heating the dried co-precipitate to a temperature sufficient to decompose or otherwise volatilize any remaining quaternary ammonium and nitrate material and to achieve partial conversion of carbonates in the co-precipitate to oxides.

16. Organic-free composition of Claim 15 wherein L is at least one metal of the rare earth group, including scandium and yttrium; M is at least one metal of the group Ba, Be, Mg, Ca, and Sr; A is at least one metal of the group Cu, Ag, and Au; and O is oxygen; and where said soluble salts of L, M, and A are nitrates.

17. Process comprising reacting in aqueous medium at a pH of about 7.7 - 10.0, carbonate ions from quaternary ammonium carbonate with ions of at least two metals that form water-insoluble carbonates, thereby to form a slurry comprising co-precipitates of the respective metal carbonates, homogeneous at the atomic level, and substantially free of extraneous materials.

18. Process according to claim 17 wherein at least one of the metals is of the group: the rare earths, the alkaline earths; Cu, Ag, and Au; Mn, Fe, Co, and Ni; Zn, Cd, and Hg; Pb and Bi; and Sc, Y, and Zr.

19. Process according to claim 17 comprising reacting in aqueous medium, carbonate ions from quaternary ammonium carbonate, with L.M.A. metal ions thereby to form a slurry comprising precipitates of the respective metal carbonates, and recovering and drying the precipitates; L being at least one trivalent metal, M being at least one bivalent metal, and A being at least one metal of multiple valency; and L, M, and A being present in a predetermined atomic ratio for a superconductor.

20. Process according to Claim 19 wherein following drying the precipitate, the precipitate is heated to a temperature sufficient to decompose or otherwise volatilize any remaining quaternary ammonium and nitrate material and to achieve partial conversion of carbonates in the co-precipitate to oxides.

21. Process according to Claim 20 wherein L is at least one metal of the rare earth group, including scandium and yttrium; M is at least one metal of the group Ba, Be, Mg, Ca, and Sr; A is at least one metal of the group Cu, Ag, and Au; and O is oxygen.

22. Process according to Claim 19 wherein L is at least one metal of the rare earth group including scandium and yttrium; M is at least one metal of the group Ba, Be, Mg, Ca, and Sr; and A is at least one metal of the group Cu, Ag and Au.

23. Process according to Claim 22, wherein, following drying the precipitate, the precipitate is calcined to an initial temperature of about 850°-1050°C; held at that temperature for about 4-8

hours; and linearly cooled down to a temperature in the range of about room temperature to 250° C over about 5-12 hours, thereby forming a superconducting material.

24. Process according to Claim 22 wherein carbon dioxide is passed through aqueous tetraethylammonium hydroxide to pH of 8.3 to form tetraethylammonium carbonate plus dissolved carbon dioxide; adding the said tetraethylammonium carbonate to an aqueous solution of nitrates of yttrium, barium, and copper in a Y:Ba:Cu atomic ratio of 1:2:3 at a pH of about 7.7-8.0, thereby to precipitate the said Y, Ba, and Cu as carbonates; recovering and drying the precipitate; calcining the dried precipitate at about 950° C and cooling the calcined product to about 150° C over 8 hours.

25. Process according to Claim 22 wherein the pH of the reaction medium is maintained at about 7.5-12 during co-precipitation.

26. Process according to Claim 22 wherein the pH of the reaction medium is maintained at about 7.7-8.0 during co-precipitation.

27. Process according to Claim 22 wherein the metal ions are derived from metal nitrates.

28. Process according to Claim 22 wherein the quaternary ammonium carbonate is prepared by bubbling $CO_2$, through an aqueous solution of a quaternary ammonium hydroxide until the quaternary carbonate is stoichiometrically formed and $CO_2$ is dissolved in excess, said quaternary ammonium hydroxide having the formula:

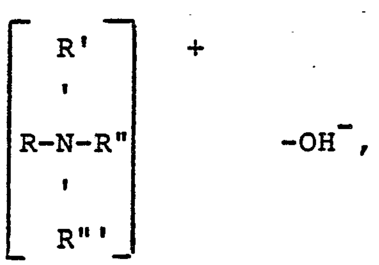

where R, R′, R″, R‴ are the same or different members of the group

i) alkyl, e.g., tetramethylammonium hydroxide, tetraethylammonium hydroxide, tetrapropylammonium hydroxide, dimethyldiethylammonium hydroxide, cyclopropyltrimethylammonium hydroxide and the like;

ii) aromatic, e.g., phenyltrimethylammonium hydroxide, phenylethyldimethylammonium hydroxide, benzyltrimethylammonium hydroxide, and the like;

iii) heterocyclic;

iv) and any two group members may be joined in a ring whereby N becomes a ring member, e.g., dimethyl pyrrolidinium hydroxide, dimethylpyridinium hydroxide, and the like.

29. Process according to Claim 22 wherein L.M.A. is $Y.Ba_2Cu_3$ and quaternary ammonium carbonate is tetramethylammonium carbonate or tetraethylammonium carbonate.

30. Process according to Claim 29, wherein, following drying the precipitate, the precipate is calcined to an initial temperature of about 850°-1050°; held at that temperature for about 4-8 hours; and linearly cooled down to a temperature in the range of about room temperature to 250° C over about 5-12 hours, thereby forming a superconducting material.

Claims for the following Contracting State: ES:

1. Process comprising reacting in aqueous medium at a pH of about 7.7 - 10.0, carbonate ions from quaternary ammonium carbonate with ions of at least two metals that form water-insoluble carbonates, thereby to form a slurry comprising co-precipitates of the respective metal carbonates, homogeneous at the atomic level, and substantially free of extraneous materials.

2. Process according to claim 1 wherein at least one of the metals is of the group: the rear earths, the alkaline earths, Cu, Ag, and Au; Mn, Fe, Co, and Ni; Zn, Cd, and Hg; Pb and Bi; and Sc, Y, and Zr.

3. Process according to claim 1 comprising reacting in aqueous medium, carbonate ions from quaternary ammonium carbonate, with L.M.A. metal ions thereby to form a slurry comprising precipitates of the respective metal carbonates, and recovering and drying the precipitates; L being at least one trivalent metal, M being at least one bivalent metal, and A being at least one metal of multiple valency; and L, M, and A being present in a predetermined atomic ratio for a superconductor.

4. Process according to Claim 3 wherein following drying the precipitate, the precipitate is heated to a temperature sufficient to decompose or otherwise volatilize any remaining quaternary ammonium and nitrate material and to achieve partial conversion of carbonates in the co-precipitate to oxides.

5. Process according to Claim 4 wherein L is at least one metal of the rare earth group, including scandium and yttrium; M is at least one metal of the group Ba, Be, Mg, Ca, and Sr; A is at least one metal of the group Cu, Ag, and Au; and O is oxygen.

6. Process according to Claim 3 wherein L is at least one metal of the rare earth group including scandium and yttrium; M is at least one metal of the group Ba, Be, Mg, Ca, and Sr; and A is at least one metal of the group Cu, Ag and Au.

7. Process according to Claim 6, wherein, following drying the precipitate, the precipitate is calcined to an initial temperature of about 850°-1050°C; held at that temperature for about 4-8 hours; and linearly cooled down to a temperature in the range of about room temperature to 250°C over about 5-12 hours, thereby forming a superconducting material.

8. Process according to Claim 6 wherein carbon dioxide is passed through aqueous tetraethylammonium hydroxide to pH of 8.3 to form tetraethylammonium carbonate plus dissolved carbon dioxide; adding the said tetraethylammonium carbonate to an aqueous solution of nitrates of yttrium, barium, and copper in a Y:Ba:Cu atomic ratio of 1:2:3 at a pH of about 7.7-8.0, thereby to precipitate the said Y, Ba, and Cu as carbonates; recovering and drying the precipitate; calcining the dried precipitate at about 950°C and cooling the calcined product to about 150°C over 8 hours.

9. Process according to Claim 6 wherein the pH of the reaction medium is maintained at about 7.5-12 during co-precipitation.

10. Process according to Claim 6 wherein the pH of the reaction medium is maintained at about 7.7-8.0 during co-precipitation.

11. Process according to Claim 6 wherein the metal ions are derived from metal nitrates.

12. Process according to Claim 6 wherein the quaternary ammonium carbonate is prepared by bubbling $CO_2$, through an aqueous solution of a quaternary ammonium hydroxide until the quaternary carbonate is stoichiometrically formed and $CO_2$ is dissolved in excess, said quaternary ammonium hydroxide having the formula:

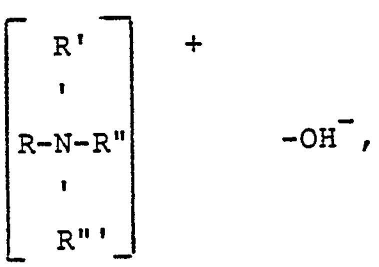

where R, R′, R″, R‴ are the same or different members of the group

i) alkyl, e.g., tetramethylammonium hydroxide, tetraethylammonium hydroxide, tetrapropylammonium hydroxide, dimethyldiethylammonium hydroxide, cyclopropyltrimethylammonium hydroxide and the like;

ii) aromatic, e.g., phenyltrimethylammonium hydroxide, phenylethyldimethylammonium hydroxide, benzyltrimethylammonium hydroxide, and the like;

iii) heterocyclic;

iv) and any two group members may be joined in a ring whereby N becomes a ring member, e.g., dimethyl pyrrolidinium hydroxide, dimethylpyridinium hydroxide, and the like.

13. Process according to Claim 6 wherein L.M.A. is $Y.Ba_2Cu_3$ and quaternary ammonium carbonate is tetramethylammonium carbonate or tetraethylammonium carbonate.

14. Process according to Claim 13, wherein, following drying the precipitate, the precipate is calcined to an initial temperature of about 850°-1050°; held at that temperature for about 4-8 hours; and linearly cooled down to a temperature in the range of about room temperature to 250°C over about 5-12 hours, thereby forming a superconducting material.

15. Composition consisting of an oxide containing at least two metals, the metals being those that form water-soluble carbonates, characterized in that the oxide is homogenous at the atomic level and is free from extraneous materials.

16. Composition according to Claim 15 wherein at least one of the metals is of the group: the rate earths; the alkaline earths; Cu, Ag, and Au; Mn, Fe, Co, and Ni; Zn, Cd, and Hg; Pb and Bi; and Sc, Y, and Zr.

17. Superconducting metal oxide compositions L.M.A.O. in which L is at least one trivalent metal, M is at least one bivalent metal, A is at least one metal of multiple valency; and in which L, M, and A are present in the predetermined atomic ratio for the superconductor;
characterized in that the composition is free of extraneous materials.

18. Composition according to Claim 17 in which L is Y, M is Ba, A is Cu, in a respective atomic ratio of 1:2:3.

19. Composition according to Claim 17, being $La_{0.7}Sr_{0.3}CoO_3$.

20. The superconducting composition of Claim 17 wherein L is at least one metal of the rare earth group, including scandium and yttrium; M is at least one metal of the group Ba, Be, Mg, Ca, and Sr; A is at least one metal of the group Cu, Ag, and Au; and O is oxygen.

21. The superconducting composition of Claim 20 which is a product of a process comprising the steps of:

(a) preparing a solution of soluble salts of L, M, and A with the components L, M, and A in said predetermined atomic ratio;

(b) preparing a solution of quaternary ammonium carbonate;

(c) mixing said L.M.A. and quaternary ammonium carbonate solutions by simultaneously stirring them into a pool of water to form a stoichiometric co-precipitate;

(d) recovering said co-precipitate; and

(e) calcining the co-precipitate.

22. The superconducting composition of Claim 21 which is produced by a process in which calcining is accomplished by heating the dried co-precipitate to a temperature of about 850°-1050°C; holding that temperature for about 4-8 hours; and linearly cooling down to a temperature in the range of about room temperature to 250°C over about 5-12 hours.

23. Aqueous slurry consisting essentially of a homogeneous dispersion of a coprecipitate of at least two metal carbonates and quaternary ammonium salts.

24. Slurry according to claim 23 wherein at least one of the metal carbonates is a carbonate of a metal of the group: the rare earths, the alkaline earths; Cu, Ag, and Au; Mn, Fe, Co, and Ni; Zn, Cd, and Hg; Pb and Bi; and Sc, Y, and Zr.

25. Aqueous slurry consisting essentially of homogeneous dispersion of L.M.A. carbonates and quaternary ammonium salts, where L is at least one trivalent metal, M is at least one bivalent metal; and A is at least one metal of multiple valency.

26. The aqueous slurry of Claim 25 where L is at least one metal of the rare earth group including scandium and yttrium; M is at least one metal of the group Ba, Be, Mg, Ca, and Sr; and A is at least one metal of the group Cu, Ag, and Au.

27. Slurry according to Claim 25 wherein L.M.A. is Y.Ba.Cu in an atomic ratio of 1:2:3.

28. Aqeuous slurry according to Claim 27 consisting essentially of

i) L.M.A. carbonates, about 0.5-75 wt%;

ii) quaternary ammonium cations, about 0.1-75 wt%;

iii) anions residual from the starting L.M.A. salts, stoichiometrically equivalent to the L.M.A. carbonates; and

iv) balance, water.

29. Organic-free composition suitable for transformation by calcination into a superconducting metal oxide L.M.A.O., where L is at least one trivalent metal, M is at least one bivalent metal, and A is at least one metal of multiple valency; in which L, M, and A are present in a predetermined atomic ratio, which organic-free composition is a product of a process comprising the steps of:

(a) preparing a solution of soluble salts of L, M, and A with the components L, M, and A in said predetermined atomic ratio;

(b) preparing a solution of quaternary ammonium carbonate;

(c) mixing said L.M.A. and quaternary ammonium carbonate solutions by simultaneously stirring them into a pool of water to form a stoichiometric co-precipitate;

(d) recovering said co-precipitate; and

(e) heating the dried co-precipitate to a temperature sufficient to decompose or otherwise volatilize any remaining quaternary ammonium and nitrate material and to achieve partial conversion of carbonates in the co-precipitate to oxides.

30. Organic-free composition of Claim 29 wherein L is at least one metal of the rare earth group, including scandium and yttrium; M is at least one metal of the group Ba, Be, Mg, Ca, and Sr; A is at least one metal of the group Cu, Ag, and Au; and O is oxygen; and where said soluble salts of L, M, and A are nitrates.